# EUROPEAN PATENT APPLICATION

(11) **EP 4 333 579 A1**
(43) Date of publication of application: **06.03.2024**
(21) Application number: 22819412.2
(22) Date of filing: 31.05.2022
(51) Int. Cl.: H05K 7/20, H01L 23/40

(54) **ELASTIC ASSEMBLY, HEAT DISSIPATION APPARATUS, ELECTRONIC DEVICE, CIRCUIT MODULE, AND ASSEMBLY METHOD THEREFOR**

(30) Priority: 07.06.2021 CN 202110632598
(71) Applicant: Huawei Technologies Co., Ltd., Longgang Shenzhen, Guangdong 518129 (CN)
(72) Inventor: JIAO, Zelong, Shenzhen, Guangdong 518129 (CN); LIU, Yongliang, Shenzhen, Guangdong 518129 (CN); SONG, Gongbin, Shenzhen, Guangdong 518129 (CN)
(74) Representative: Grünecker Patent- und Rechtsanwälte PartG mbB
(86) International application number: PCT/CN2022/096214
(87) International publication number: WO 2022/257814

(57) **Abstract**

This application relates to the field of communication technologies, and discloses a captive elastic assembly, a heat dissipation apparatus, an electronic device, and a circuit module and an assembly method thereof. After a connecting component and a fastening component in the captive elastic assembly have been mounted, an anti-stripping spacing for preventing a second member from being stripped from a first member can be formed by a nail body, an elastic element, and an anti-stripping member in the connecting component, then a fixed spacing for fastening the second member to a third member can be formed by the fastening component and the nail body in the connecting component, and finally an elastic spacing for elastically combining the first member to the second member, that is, elastically combining the first member to the third member is formed by the fastening component and the nail body and the elastic element in the connecting component. When the captive elastic assembly implements the foregoing three functions, a quantity of holes on a circuit board for mounting the foregoing connecting pieces is reduced maximally, thereby improving utilization of a surface of the board and improving flexibility of high-density layout of the board.

## Description

This application claims priority to Chinese Patent Application No. 202110632598.6, filed on June 7, 2021 and entitled "ELASTIC ASSEMBLY, HEAT DISSIPATION APPARATUS, ELECTRONIC DEVICE, AND CIRCUIT MODULE AND ASSEMBLY METHOD THEREOF", which is incorporated herein by reference in its entirety.

### TECHNICAL FIELD

The present invention relates to the field of communication technologies, and in particular, to a captive elastic assembly, a heat dissipation apparatus, an electronic device, and a circuit module and an assembly method thereof.

### BACKGROUND

With the advent of the big data era, a data transmission rate is continuously increased, a computing processing capability of an electronic device is continuously improved, and power consumption of a corresponding chip is rapidly increased, resulting in higher heat consumption of the chip. To ensure contact effect between a pin or a solder ball in a chip package structure and a circuit board for better signal transmission reliability, a current common solution is to add a metal bracket around a chip on the circuit board, to strengthen strength of a circuit board in an area where the chip package structure is located by using the bracket, and limit deformation of the circuit board in a temperature change process of the chip package structure within a specific range, so as to ensure the contact effect between the pin or the solder ball in the chip package structure and the circuit board, and improve the signal transmission reliability. However, adding the bracket in the circuit module leads to a cumbersome mounting process of the circuit module.

### SUMMARY

This application is to provide a captive elastic assembly, a heat dissipation apparatus, an electronic device, and a circuit module and an assembly method thereof. The captive elastic assembly includes a connecting component and a fastening component, and the connecting component can prevent a bracket from being stripped from a heat sink. The connecting component and the fastening component collaboratively fasten the bracket on a circuit board and elastically abut the heat sink on the bracket, that is, elastically abut the heat sink on a package structure of the circuit board. The foregoing captive elastic assembly can implement the foregoing three functions with no need to add a mounting hole on the circuit board, thereby improving utilization of a surface of the circuit board and improving flexibility of high-density layout of the board.

A first aspect of this application provides a captive elastic assembly. Specifically, the captive elastic assembly includes a connecting component and a fastening component. The connecting component includes a nail body, an elastic element, and an anti-stripping member, and the nail body includes a connector, a large-diameter connecting rod, and a small-diameter connecting rod that are sequentially connected. The elastic element is sleeved on the large-diameter connecting rod and abuts on the connector, the anti-stripping member is mounted on the small-diameter connecting rod, and the fastening component is mounted on a fastening end that is of the connecting component and that is opposite to the connector. An anti-stripping spacing capable of restricting a second member from being stripped from a first member is formed between the elastic element and the anti-stripping member. A fixed spacing capable of fastening the second member and a third member is formed between the fastening component and the large-diameter connecting rod. An elastic spacing capable of elastically combining the first member to the second member is formed between the fastening component and the elastic element.

In other words, in embodiments of this application, after the connecting component (including the nail body, the elastic element, and the anti-stripping member) and the fastening component that are in the captive elastic assembly have been mounted, the anti-stripping spacing for preventing the second member from being stripped from the first member can be first formed by the nail body, the elastic element, and the anti-stripping member that are in the connecting component, then the fixed spacing for fastening the second member to the third member can be formed by the fastening component and the nail body in the connecting component, and finally the elastic spacing for elastically combining the first member to the second member, that is, elastically combining the first member to the third member is formed by the fastening component and the nail body and the elastic element that are in the connecting component.

The first member may be a heat sink in a circuit module, the second member may be a bracket in the circuit module, the third member may be a circuit board in the circuit module, and the circuit board is provided with a package structure. In the circuit module, the heat sink is elastically combined to the circuit board, to dissipate heat for the package structure on the circuit board.

The "anti-stripping" means that the bracket cannot be stripped from the heat sink. For example, the bracket is elastically combined to the heat sink by using the captive elastic assembly. For another example, the bracket and the heat sink are connected in series to the captive elastic assembly, and the bracket and the heat sink can slide along the captive elastic assembly. The connecting component is a component that is used to connect the bracket to the heat sink when the heat sink is assembled in a case that the heat sink is mounted on the circuit board, to implement integration assembly of the bracket and the heat sink and to implement a fixed connection between the bracket and the circuit board and an elastic combination between the heat sink and the circuit board through cooperation between the fastening component and the connecting component. The fastening component refers to a structure in which the bracket is fastened to the circuit board and the heat sink is elastically combined to the bracket through cooperation between the heat sink and the connecting component on the heat sink after the heat sink is assembled. The fastening end refers to a structure on the connecting component for mounting the fastening component. For example, the fastening end may be an end that is of the connecting component and that is opposite to the connector, and the fastening end may also be an end that is of the small-diameter connecting rod of the nail body and that is opposite to the connector. The end opposite to the connector is an end that is of the small-diameter connecting rod (the connecting component) and that is further away from the connector.

For example, the nail body includes a connector, a large-diameter connecting rod, and a small-diameter connecting rod whose outer diameters are sequentially reduced and connected along a same direction. An annular connector end face is formed at an end that is of the connector and that is connected to the large-diameter connecting rod. An annular large-diameter end face is formed at an end that is of the large-diameter connecting rod and that is connected to the small-diameter connecting rod. The elastic element is in a spiral rotary structure, and the elastic element includes a first elastic end and a second elastic end. The anti-stripping member is a screw cap, and the anti-stripping member is formed with a mounting internal thread that adapts to a mounting end of the nail body and an anti-stripping end face used to restrict the bracket from being stripped from the heat sink.

When the nail body, the elastic element, and the anti-stripping member that are in the connecting component have been assembled, the elastic element is sleeved on the large-diameter connecting rod of the nail body, the first elastic end of the elastic element can be used to abut on the end face of the connector, and the second elastic end of the elastic element can be used to abut on the heat sink. The anti-stripping end face of the anti-stripping member faces the large-diameter end face of the large-diameter connecting rod of the nail body. The anti-stripping spacing is a spacing between the anti-stripping end face and the second elastic end of the elastic element after the captive elastic assembly is mounted on the heat sink and the bracket.

When the fastening component is mounted on the fastening end of the connecting component, the fixed spacing is a spacing between a fastening end face of the fastening component and the large-diameter end face of the large-diameter connecting rod after the heat sink and the bracket are mounted on the circuit board by using the captive elastic assembly. The elastic spacing is a spacing between the fastening end face of the fastening component and the second elastic end of the elastic element after the heat sink and the bracket are mounting on the circuit board by using the captive elastic assembly.

The fastening component may be mounted on the fastening end of the connecting component through a threaded connection. The fastening component may also be mounted on the fastening end of the connecting component through self-clinching or anchor riveting.

After the connecting component (including the nail body, the elastic element, and the anti-stripping member) and the fastening component that are in the foregoing captive elastic assembly have been mounted, the anti-stripping spacing for preventing the bracket from being stripped from the heat sink can be first formed, then the fixed spacing for fastening the bracket to the circuit board can be formed, and finally the elastic spacing for elastically combining the heat sink to the bracket, that is, elastically combining the heat sink to the circuit board can be formed. In other words, stripping of the bracket from the heat sink, the fixed connection between the bracket and the circuit board, and the elastic combination between the heat sink and the bracket can be limited by connecting the heat sink, the bracket, and the circuit board by using the foregoing captive elastic assembly. When implementing the foregoing three functions, a quantity of the connecting pieces is reduced as much as possible, that is, a quantity of holes on the circuit board for mounting the foregoing connecting pieces is reduced as much as possible, thereby reducing occupation of mounting space on a surface of the circuit board, improving utilization of the surface of the circuit board surface, and improving flexibility of high-density layout of the board.

In a possible implementation of the first aspect, in the captive elastic assembly, the anti-stripping member includes a screw cap, the screw cap is threadedly connected to an end that is of the small-diameter connecting rod and that is opposite to the connector, and the screw cap is used to adjust the anti-stripping spacing by adjusting a length of the threaded connection between the screw cap and the small-diameter connecting rod.

In other words, in embodiments of this application, in the foregoing captive elastic assembly, the end that is of the small-diameter connecting rod and that is opposite to the connector is a mounting end used to connect the anti-stripping member, and the mounting end has a mounting external thread. The anti-stripping member in the connecting component is the screw cap, and the screw cap has a mounting internal thread that adapts to the mounting external thread on the mounting end of the small-diameter connecting rod. The mounting external thread on the small-diameter connecting rod is screwed to the mounting internal thread on the anti-stripping member to implement the threaded connection between the small-diameter connecting rod and the anti-stripping member.

In the foregoing captive elastic assembly, the anti-stripping member is set as the screw cap, and a connection manner between the anti-stripping member and the small-diameter connecting rod is set as the thread connection. Therefore, the anti-stripping spacing can be flexibly adjusted while strength of the connection between the anti-stripping member and the nail body is ensured. This avoids mechanical impact of the heat sink on the bracket during transportation due to small sizes of the heat sink and the bracket and a large anti-stripping spacing between the heat sink and the bracket and further optimizes service performance of the captive elastic assembly.

In a possible implementation of the first aspect, in the captive elastic assembly, the fastening end includes the screw cap and the end that is of the small-diameter connecting rod and that is opposite to the connector, and an external thread is arranged on an outer periphery of the screw cap, and the fastening component is screwed to the external thread through an internal thread of the fastening component to be threadedly mounted with the fastening end.

In other words, in embodiments of this application, the fastening component is provided with a fastening internal thread, and the fastening end of the connecting component includes the end that is of the small-diameter connecting rod and that is opposite to the connector and the screw cap mounted on the small-diameter connecting rod. A fastening external thread that adapts to the fastening internal thread on the fastening component is arranged on the outer periphery of the screw cap. The fastening external thread on the screw cap is screwed to the fastening internal thread of the fastening component to implement a thread connection between the screw cap and the fastening component, and further implement a thread connection between the small-diameter connecting rod and the fastening component, that is, implement a thread connection between the nail body and the fastening component, and finally implement the thread connection between the connecting component and the small-diameter connecting rod.

In the foregoing captive elastic assembly, a connection manner between the connecting component and the fastening component is set as the thread connection. After the fastening component is mounted on the connecting component, a heat source of the heat sink on the circuit board can be adjusted by adjusting a length of the thread connection between the connecting component and the fastening component or a position of the thread connection between the connecting component and the fastening component. This avoids mechanical impact of the heat sink on the bracket during transportation due to small sizes of the heat sink and the bracket and a large elastic spacing, further optimizes performance of the captive elastic assembly, and reduces mounting difficulty of the captive elastic assembly.

In a possible implementation of the first aspect, in the captive elastic assembly, the fastening end includes the screw cap and the end that is of the small-diameter connecting rod and that is opposite to the connector, and the fastening component is mounted on the fastening end through self-clinching or anchor riveting.

In the foregoing captive elastic assembly, a connection manner between the connecting component and the fastening component is set as the self-clinching or anchor riveting. This can avoid a problem that the bracket is stripped from the circuit board because the fastening component or the connecting component is accidentally touched after the captive elastic assembly is assembled on the heat sink, the bracket, and the circuit board, and consequently the heat sink cannot be tightly elastically combined to a surface of the package structure on the circuit board, and heat dissipation effect of the heat sink on the package structure is affected.

In a possible implementation of the first aspect, in the captive elastic assembly, the anti-stripping member includes a stopper, the stopper is clamped to the small-diameter connecting rod, and the stopper is configured to adjust the anti-stripping spacing by adjusting a clamping position between the stopper and the small-diameter connecting rod.

In the foregoing captive elastic assembly, the anti-stripping member is set as the limit plate, and a connection manner between the connecting component and the fastening component is set as the clamping connection, so that processing difficulty of the mounting end in the connecting component is reduced, mounting difficulty of the anti-stripping member is reduced at the same time, and mounting efficiency of the captive elastic assembly is improved.

In a possible implementation of the first aspect, in the captive elastic assembly, the fastening end includes the end that is of the small-diameter connecting rod and that is opposite to the connector, and an external thread is arranged on an outer periphery of the end, and the fastening component is screwed to the external thread through an internal thread of the fastening component to be threadedly mounted with the fastening end.

In the foregoing captive elastic assembly, a connection manner between the connecting component and the fastening component is set as the thread connection. After the fastening component is mounted on the connecting component, a heat source of the heat sink on the circuit board can be adjusted by adjusting a length of the thread connection between the connecting component and the fastening component or a position of the thread connection between the connecting component and the fastening component. This avoids mechanical impact of the heat sink on the bracket during transportation due to small sizes of the heat sink and the bracket and a large anti-stripping spacing, further optimizes performance of the captive elastic assembly, and reduces mounting difficulty of the captive elastic assembly. In addition, the fastening end is a part of the small-diameter connecting rod, to avoid affecting linkage of another member in the connecting component when fastening effect between the connecting component and the fastening component is adjusted, thereby reducing debugging difficulty of the captive elastic assembly.

A second aspect of this application provides a heat dissipation apparatus. The heat dissipation apparatus includes a heat sink, a bracket, and any captive elastic assembly in the first aspect. The heat sink is used as the first member, the heat sink is provided with a first through hole, and an aperture of the first through hole is less than a spiral outer diameter of the elastic element. The bracket is used as the second member, the bracket is provided with a second through hole, and an aperture of the second through hole is smaller than a diameter of the large-diameter connecting rod and an outer diameter of the anti-stripping member. The connector is located on a side of the heat sink, the large-diameter connecting rod penetrates the first through hole, the elastic element is sleeved on the large-diameter connecting rod between the connector and the heat sink, the small-diameter connecting rod penetrates through the second through hole, and the anti-stripping member is mounted on an end that is of the small-diameter connecting rod and that penetrates out the second through hole. The elastic element and the anti-stripping member are capable of restricting the bracket from being stripped from the heat sink. When the connecting component penetrates through the third member and is mounted on the fastening component, to mount the heat sink and the bracket on the third member, the large-diameter connecting rod and the fastening component tightly press the bracket and the third member. The heat sink is elastically combined to the bracket through elastic deformation of the elastic element.

In other words, in embodiments of this application, a connector diameter of the connector is greater than the spiral outer diameter of the elastic element. The aperture of the first through hole in the heat sink is less than the spiral outer diameter of the elastic element, and the aperture of the first through hole is greater than a large-diameter of the large-diameter connecting rod. The aperture of the second through hole in the bracket is smaller than the large-diameter of the large-diameter connecting rod and an anti-stripping outer diameter of the anti-stripping member, and the aperture of the second through hole is greater than a small diameter of the small-diameter connecting rod. For example, the small-diameter connecting rod is threadedly connected to the bracket.

In the heat dissipation apparatus, the connector is located on the side of the heat sink, the large-diameter connecting rod penetrates the first through hole of the heat sink, the elastic element is sleeved on the large-diameter connecting rod between the connector and the heat sink, the small-diameter connecting rod penetrates through the second through hole of the bracket, and the anti-stripping member is mounted on the end (that is, a mounting end of the nail body) that is of the small-diameter connecting rod and that penetrates out the second through hole. The nail body and the elastic element cooperate with the anti-stripping member to restrict the bracket from being stripped from the heat sink.

In the heat dissipation apparatus, the captive elastic assembly restricts the bracket from being stripped from the heat sink, so that overall integration assembly of the heat dissipation apparatus is implemented. In addition, the captive elastic assembly can further implement a fixed connection between the bracket and the circuit board and an elastic combination between the heat sink and the bracket. When the foregoing heat dissipation apparatus implements the foregoing three functions, a small quantity of connecting pieces are required, which simplifies assembly difficulty of the heat dissipation apparatus and mounting difficulty of mounting the heat dissipation apparatus on the circuit board. In addition, the heat dissipation apparatus further reduces a quantity of holes on the circuit board for mounting the heat dissipation apparatus, thereby reducing occupation of mounting space on a board surface of the circuit board, improving utilization of the board surface, improving flexibility of high-density layout of the board, and improving assembly efficiency.

In a possible implementation of the second aspect, in the heat dissipation apparatus, a quantity of the captive elastic assemblies is 4, and the four captive elastic assemblies are distributed in an array in an area in which the bracket is located.

In the heat dissipation apparatus, the quantity of the captive elastic assemblies is properly set and distribution positions of the captive elastic assemblies are properly arranged, so that manufacturing costs are saved, assembly efficiency is improved, stability of the structure of the heat dissipation apparatus can be improved, and stability of an entire structure of the circuit module is further improved.

A third aspect of this application provides a circuit module. The circuit module includes any heat dissipation apparatus in the second aspect, a circuit board, and a package structure mounted on the circuit board. The circuit board is used as the third member, and the circuit board is provided with a third through hole corresponding to the first through hole and the second through hole. The connecting component is mounted on the fastening component through the third through hole, the large-diameter connecting rod and the fastening component tightly press the bracket and the circuit board, and the heat sink is elastically combined to the bracket through elastic deformation of the elastic element.

In other words, in embodiments of this application, an aperture of the third through hole on the circuit board is greater than an anti-stripping outer diameter of the anti-stripping member, and the aperture of the third through hole is less than a fastening outer diameter of the fastening component. The heat sink is configured to dissipate heat for the package structure on the circuit board, the package structure is provided with a heat-conducting surface, and the heat sink is provided with a heat-absorbing surface that adapts to the heat-conducting surface. The circuit board is located on a side that is of the bracket and that faces away from the heat sink, the package structure mounted on the circuit board faces the heat sink, and the heat-conducting surface of the package structure penetrates through a hollowed-out part of the bracket and abuts on the heat-absorbing surface of a boss of the heat sink.

In another implementation of this application, the side that is of the bracket and that faces away from the heat sink is provided with a countersink hole. The countersink hole is coaxially disposed with the second through hole on the bracket, and an aperture of the countersink hole is greater than the anti-stripping outer diameter of the anti-stripping member. It may be understood that the aperture of the third through hole on the circuit board and the anti-stripping member are not specifically limited.

The circuit module can effectively control increasing of a quantity of connecting pieces when implementing the three states of the anti-stripping, the fixed connection, and the elastic connection, thereby simplifying mounting difficulty of the circuit module, improving an assembly speed of the circuit module, and improving economic benefit. In addition, the circuit module further reduces a quantity of holes on the circuit board for mounting the heat dissipation apparatus, thereby reducing occupation of mounting space on a board surface of the circuit board, improving utilization of the board surface, and improving flexibility of high-density layout of the board.

In a possible implementation of the third aspect, the circuit module further includes a fireproof panel, the fireproof panel is disposed on a side that is of the circuit board and that is away from the package structure, and the fastening component is disposed on the fireproof panel. The fireproof panel can be used to prevent fire from being caused by an excessive high temperature of the package structure on the circuit board, and also provides a mounting basis for the fastening component.

A fourth aspect of this application provides an electronic device. The electronic device includes any circuit module in the third aspect.

The electronic device further reduces a quantity of holes on the circuit board for mounting the heat dissipation apparatus, thereby reducing occupation of mounting space on a board surface of the circuit board, improving utilization of the board surface, improving flexibility of high-density layout of the board, and improving an assembly speed of the circuit board.

A fifth aspect of this application provides an assembly method of the circuit module. The assembly method of the circuit module is used to assemble any circuit module in the third aspect, and the assembly method includes: sleeving the elastic element on the large-diameter connecting rod; sequentially penetrating the end that is of the small-diameter connecting rod and that is opposite to the connector through the first through hole on the heat sink and the second through hole on the bracket; mounting the anti-stripping member on the end that is of the small-diameter connecting rod and that is opposite to the connector, to restrict the bracket from being stripped from the heat sink; penetrating the fastening end of the connecting component through the third through hole on the circuit board; and mounting the fastening end on the fastening component, so that the large-diameter connecting rod and the fastening component tightly press the bracket and the circuit board, and the heat sink is elastically combined to the bracket through elastic deformation of the elastic element. It may be understood that, the assembly method of the circuit module may be: first assembling the heat dissipation apparatus according to the foregoing method, and then mounting the heat dissipation apparatus on the circuit board.

In the assembly method of the circuit module, the heat sink and the bracket can be combined by using the captive elastic assembly to implement integration assembly of the heat sink and the bracket, and then the heat dissipation apparatus can be mounted on the circuit board by using the captive elastic assembly, thereby reducing steps of mounting the circuit module on site and reducing difficulty of mounting the circuit module on site. Then, the structure of the captive elastic assembly reduces the quantity of connecting pieces in the circuit module, and further improves mounting efficiency of the circuit module. Finally, the heat sink is first mounted on the bracket, and then the bracket is mounted on the circuit board. This can effectively avoid the heat sink from scratching a surface of the package structure during aligning the heat sink with the bracket, thereby improving a yield rate of the circuit module.

### BRIEF DESCRIPTION OF DRAWINGS

FIG. 1(a) is a bottom view of a ball grid array package;
FIG. 1(b) is a side view of a joint between a ball grid array package and a circuit board;
FIG. 2 is an exploded view of a circuit module according to this application;
FIG. 3(a) is a schematic top view of a circuit module in another technical solution, and a heat sink is not shown;
FIG. 3(b) is a schematic top view of a circuit module 2 according to this application, and a heat sink is not shown;
FIG. 4 is a cross-sectional view of a heat sink 20 along a section A-A in FIG. 2 according to Embodiment 1 of this application;
FIG. 5 is a cross-sectional view of a bracket 30 along a section A-A in FIG. 2 according to Embodiment 1 of this application;
FIG. 6 is a cross-sectional view of a circuit board 40 and a package structure 50 along a section A-A in FIG. 2 according to Embodiment 1 of this application;
FIG. 7 is a cross-sectional view of a captive elastic assembly 10 along a section A-A in FIG. 2 according to Embodiment 1 of this application;
FIG. 8(a) is a side view of a nail body 100 according to Embodiment 1 of this application;
FIG. 8(b) is a side view of an elastic element 200 according to Embodiment 1 of this application;
FIG. 8(c) is a cross-sectional view of an anti-stripping member 300 along a section A-A in FIG. 2 according to Embodiment 1 of this application;
FIG. 8(d) is a cross-sectional view of a fastening component 12 along a section A-A in FIG. 2 according to Embodiment 1 of this application;
FIG. 9 is a cross-sectional view of a heat dissipation apparatus 1 along a section A-A in FIG. 2 according to Embodiment 1 of this application;
FIG. 10 is a flowchart of an assembly method of a heat dissipation apparatus 1 according to Embodiment 1 of this application;
FIG. 11 is a cross-sectional view of a circuit module 2 along a section A-A in FIG. 2 according to Embodiment 1 of this application;
FIG. 12(a) is a schematic top view of a circuit module 2 according to this application, and a heat sink is not shown;
FIG. 12(b) is a schematic top view of a circuit module in another technical solution, and a heat sink is not shown;
FIG. 13 is a flowchart of an assembly method of a circuit module 2 according to Embodiment 1 of this application;
FIG. 14 is a cross-sectional view of a captive elastic assembly 10' along a section A-A in FIG. 2 according to Embodiment 2 of this application;
FIG. 15 is a sectional view of a heat dissipation apparatus 1' along a section A-A in FIG. 2 according to Embodiment 2 of this application; and
FIG. 16 is a cross-sectional view of a circuit module 2' along a section A-A in FIG. 2 according to Embodiment 2 of this application.

### Reference numerals:

In other technical solutions:
20-heat sink;
30-bracket;
40-circuit board;
50-package structure; 51-signal pin; 52-solder ball;
60-bracket screw (locking a bracket to a circuit board);
70-positioning pin; and
80-heat sink screw (locking a heat sink to a circuit board).

In Embodiment 1:
1-heat dissipation apparatus;
10-captive elastic assembly; S_{anti-stripping}-anti-stripping spacing; S_{fixed}-fixed spacing; S_{elastic}-elastic spacing;
11-connecting component;
100-nail body; la-nail body axial direction; lr-nail body radial direction; 101-mounting end;
110-connector; 110a-connector end face; D1-connector diameter;
120-large-diameter connecting rod; 120a-large-diameter end face; D2-large-diameter;
130-small connecting rod; D3-small diameter;
200-elastic element; 201-first elastic end; 202-second elastic end; D4-spiral outer diameter;
300-anti-stripping member; 300a-mounting internal thread; 300b-anti-stripping end face; 300c-fastening external thread; D5-anti-stripping outer diameter;
12-fastening component; 12a-fastening internal thread; 12b-fastening end face; D6-fastening outer diameter;
20-heat sink; 20a-heat-absorbing surface;
21-substrate; 21a-first substrate surface; 21b-second substrate surface;
22-fin;
23-boss;
24-first through hole; d1-aperture of the first through hole;
25-air duct;
30-bracket;
31-frame structure; 31a-first bracket surface; 31b-second bracket surface;
32-hollowed-out part;
33-second through hole; d2-aperture of the second through hole;
40-circuit board; 40a-first circuit board surface; 40b-second circuit board surface;
41-third through hole; d3-aperture of the third through hole;
50-package structure; 50a-heat-conducting surface;
90-fireproof panel; and
2-circuit module.

In Embodiment 2:
1'-heat dissipation apparatus;
10'-captive elastic assembly; S_{anti-stripping}'-anti-stripping spacing;
11'-connecting component;
300'-anti-stripping member; 300b'-anti-stripping end face; D5'-anti-stripping outer diameter; and
2'-circuit module.

### DESCRIPTION OF EMBODIMENTS

To make the objectives, technical solutions, and advantages of this application clearer, the following further describes the implementations of this application in detail with reference to the accompanying drawings.

As described above, a circuit board needs to be provided with an additional mounting hole for a bracket currently used to prevent warping and deformation of the circuit board. As a result, a mounting area on a board surface of the circuit board for mounting the heat sink and the bracket becomes larger, and an actual effective use area on the board surface of the circuit board is reduced.

To resolve the foregoing problem and improve actual utilization of the board surface of the circuit board, this application provides a circuit module. The circuit module includes a captive elastic assembly, a heat sink, a bracket, a circuit board, and a package structure mounted on the circuit board. The package structure is a carrier for accommodating and covering several semiconductor elements or integrated circuits, and a material of the package structure may be any one of metal, plastic, glass, and ceramic. Specifically, when a semiconductor component core or integrated circuit is etched on a wafer and after the wafer is cut into independent dies, several dies are assemblies and potted into a whole to form the package structure. The package structure can protect the die from impact and scratch, provide a pin or a contact connected to an external circuit for the die, and take away heat generated when the die is working to reduce a temperature of the die in the working state.

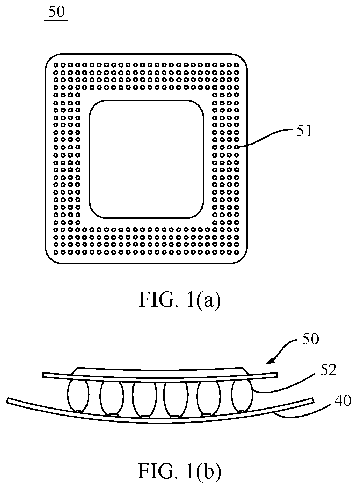

As shown in FIG. 1(a), an entire bottom surface of a ball grid array package (Ball Grid Array, BGA) in a package structure 50 can be used as signal pins 51. Compared with another package structure, the ball grid array package can provide more signal pins 51, and has better highspeed performance, so that the ball grid array package is widely used in a chip with a complex function. However, because a temperature of the chip in the ball grid array package increases when the chip is used, and a circuit board connected to the ball grid array package may be warped and deformed, as shown in FIG. 1(b), due to factors such as material, structure, shape, and mounting layout, a point at which a solder ball 52 in the ball grid array package is fused with a pad of the circuit board 40 bears large stress, and consequently contact of the solder ball 52 is unstable, reducing signal and transmission reliability.

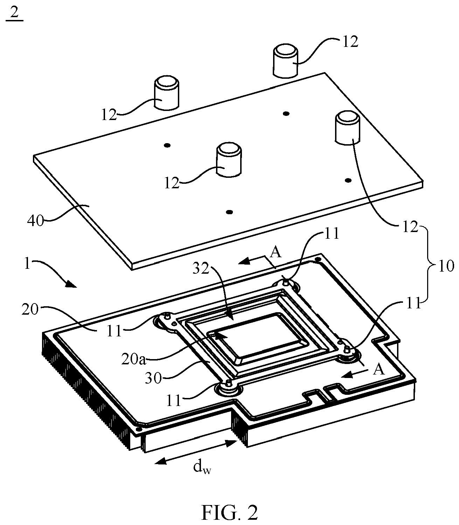

FIG. 2 is an exploded view of a circuit module 2 from upside and downside in this application, and a package structure is not shown. It can be learned from FIG. 2 that, the circuit module 2 includes a heat dissipation apparatus 1 and a circuit board 40. A board surface of the circuit board 40 is provided with a package structure. The heat dissipation apparatus 1 includes a captive elastic assembly 10, a heat sink 20, and a bracket 30.

For the heat dissipation apparatus 1, a connecting component 11 of the captive elastic assembly 10 penetrates through a first through hole (not shown) on the heat sink 20 and a second through hole (not shown) on the bracket 30. A connector (not shown in the figure) whose outer diameter is greater than an aperture of the first through hole is formed on a side that is of the heat sink 20 and that faces away from the bracket 30, and an anti-stripping member (not shown) whose outer diameter is greater than an aperture of the second through hole is formed on a side that is of the bracket 30 and that faces away from the heat sink 20. Further, the connecting component 11 cooperates with the anti-stripping member through the connector to restrict the bracket 30 from being stripped from the heat sink 20.

For the circuit module 2, the connecting component 11 in the captive elastic assembly 10 is mounted on a fastening component 12 through a third through hole (not shown) on the circuit board 40. One end face (not shown in the figure) facing the fastening component 12 is formed on the connecting component 11 and the other end face facing the connecting component 11 (a downward-facing end face of the fastening component 12 in FIG. 2) is formed on the fastening component 12. The captive elastic assembly 10 presses the bracket 30 and the circuit board 40 through cooperation between the one end face and the other end face, to implement a fixed connection between the bracket 30 and the circuit board 40. In addition, the connecting component 11 further includes an elastic element (not shown in the figure). The captive elastic assembly 10 is elastically deformed through the elastic element, and cooperates with the fastening component 12, to elastically combine the heat sink 20 to the bracket 30. Because the bracket 30 and the circuit board 40 are fixedly connected, the heat sink 20 is elastically combined to the circuit board 40, and further a heat-absorbing surface 20a of the heat sink 20 is elastically abutted on a heat-conducting surface (not shown in the figure) mounted on the package structure (not shown in the figure) of the circuit board 40.

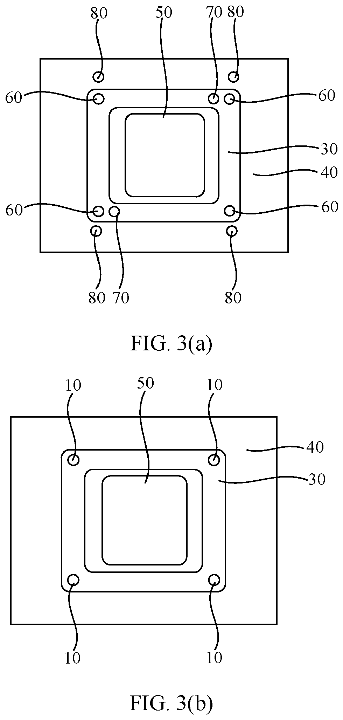

FIG. 3(a) is a schematic top view of the circuit module 2 in another technical solution (the heat sink is not shown). As shown in FIG. 3(a), in addition to the heat sink, the bracket 30, the circuit board 40, and the package structure 50 mounted on the circuit board 40, the circuit module 2 further includes a bracket screw 60 configured to mount the bracket 30 on the circuit board 40, a positioning pin 70 configured to determine a relative position between the bracket 30 and the circuit board 40 and a relative position between the heat sink and the bracket 30, and a heat sink screw 80 configured to mount the heat sink on the circuit board 40 or mount the heat sink on the bracket 30. It can be learned from FIG. 3(a) that, to implement stable connection of the heat sink, the bracket 30, and the circuit board 40, the circuit module 2 includes four bracket screws 60, two positioning pins 70, and four heat sink screws 80. In other words, a total of 10 connecting pieces are required to complete mounting of the heat sink, the bracket 30, and the circuit board 40 that are in the circuit module 2, that is, the circuit board 40 needs to be provided with 10 screw holes. To ensure reliability of the circuit module 2, a bright copper area (that is, a PCB metal layer is exposed) and a restricted wiring area (an area in which a component is prohibited to be distributed or PCB wiring is prohibited) need to be reserved around each screw hole. As a result, the screw hole occupies a large area, and finally flexibility of high-density layout of the board is reduced.

According to the technical solution in this application, FIG. 3(b) is a schematic top view of the circuit module 2 (the heat sink is not shown). The circuit module 2 in the technical solution of this application includes four captive elastic assemblies 10. A fixed connection between the bracket 30 and the circuit board 40, and an elastic combination between the heat sink and the bracket 30 can be implemented by using the four captive elastic assemblies 10. To implement the foregoing three functions of the circuit module 2, each of the heat sink, the bracket 30, and the circuit board 40 only needs to be provided with four mounting holes. Therefore, a quantity of connecting pieces on a board surface of the circuit board 40 can be reduced, thereby reducing occupation of mounting space on the board surface of the circuit board 40, improving utilization of the board surface of the circuit board 40, and further improving flexibility of high-density layout of the board.

It may be understood that, in addition to being applied to mounting of the heat sink 20 (as shown in FIG. 2) and the bracket 30 that are on the circuit board 40, the foregoing captive elastic assembly 10 may be further applied to another application scenario. For example, the captive elastic assembly 10 may be further applied to mounting of a heat sink on a surface of another heat source. An application scenario of the captive elastic assembly 10 is not specifically limited in this application. For ease of understanding, the following continues to describe in detail a specific structure, a working principle, and a mounting manner of the captive elastic assembly 10 by using an example in which the captive elastic assembly 10 is applied to the heat sink 20 and the bracket 30 that are on the circuit board 40.

The following describes in detail the captive elastic assembly 10, the heat dissipation apparatus 1, the circuit module 2, an assembly method of the circuit module 2, and an electronic device disclosed in this application.

### Embodiment 1

It can be learned from FIG. 2, FIG. 3(a) and FIG. 3(b) that this application provides a circuit module 2, including a heat dissipation apparatus 1 and a circuit board 40. The circuit board 40 is provided with a package structure 50. Further, the heat dissipation apparatus 1 includes a captive elastic assembly 10, a heat sink 20, and a bracket 30. When the heat dissipation apparatus 1 is not assembled on the circuit board 40, the captive elastic assembly 10 can restrict the bracket 30 from being stripped from the heat sink 20, to implement integration assembly of the heat sink 20 and the bracket 30. When the heat dissipation apparatus 1 is assembled on the circuit board 40, the captive elastic assembly 10 can fasten and connect the bracket 30 and the circuit board 40, and can further elastically combine the heat sink 20 to the bracket 30, so that a heat-absorbing surface 20a of the heat sink 20 is elastically abutted on a heat-conducting surface of the package structure 50.

The captive elastic assembly 10 is a connection structure between the heat sink 20, the bracket 30, and the circuit board 40. Therefore, to clearly describe a structure feature and a working principle of the captive elastic assembly 10, specific structures of the heat sink 20, the bracket 30, and the circuit board 40 (including the package structure 50 mounted on the circuit board 40) in this embodiment need to be described in advance in this application.

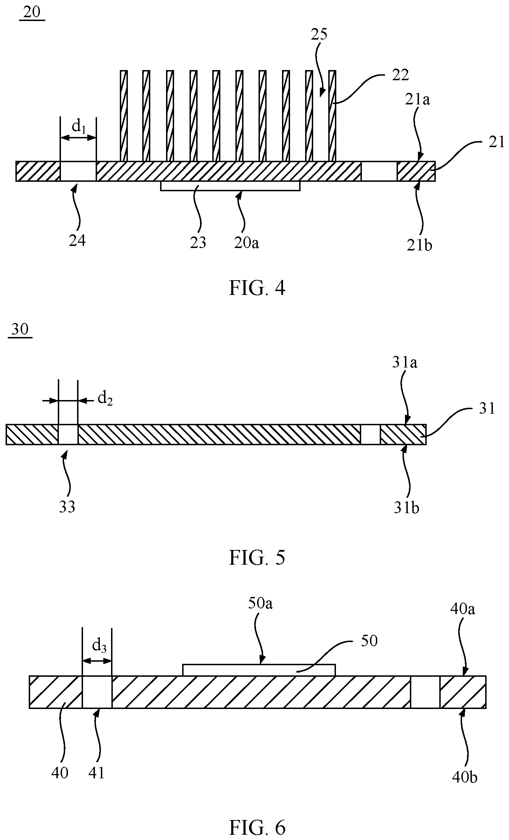

In some embodiments of this application, the heat sink 20 is an air-cooled heat sink. FIG. 4 is a cross-sectional view of an air-cooled heat sink 20 along a section A-A in FIG. 2 in Embodiment 1 of this application. The following describes in detail the specific structure of the heat sink 20 with reference to FIG. 4.

In some embodiments of this application, as shown in FIG. 4, the heat sink 20 is an air-cooled heat sink, and the heat sink 20 includes a substrate 21, fins 22, and a boss 23. The substrate 21 is formed with a first substrate surface 21a and a second substrate surface 21b that are opposite to each other and face away from each other. The substrate 21 is further provided with a first through hole 24, and the first through hole 24 connects the first substrate surface 21a and the second substrate surface 21b. For ease of subsequent description, an aperture of the first through hole 24 is denoted as d1 in this application. With reference to the foregoing description, it can be learned that the captive elastic assembly 10 is mounted on the first through hole 24 of the heat sink 20.

The fins 22 are arranged in parallel on the first substrate surface 21a of the substrate 21, and the substrate 21 and the fins 22 may be integrated by using a welding, machining, cutting, stamping, or forging process. An air duct 25 is formed between adjacent fins 22, and in a heat dissipation process, gas flows along an extension direction of the air duct 25 (a direction of gas in FIG. 2 is dw). For example, in FIG. 4, a flow direction of the gas is perpendicular to the paper outwards, or perpendicular to the paper inwards.

The boss 23 protrudes outward from the second substrate surface 21b of the substrate 21 in a direction away from the substrate 21. A side surface that is of the boss 23 and that faces away from the substrate 21 is the heat-absorbing surface 20a. Further, the heat-absorbing surface 20a is coated with a heat conducting layer, to improve heat-conducting efficiency of the heat-absorbing surface 20a, and further improve heat dissipation effect of the heat sink 20.

Specifically, with reference to FIG. 2, FIG. 3(a), FIG. 3(b), and FIG. 4, it can be learned that the boss 23 absorbs heat generated by the package structure 50 from the heat-conducting surface (not shown in the figure) of the package structure 50 by using the heat-absorbing surface 20a, and transfers the absorbed heat to the fins 22 through the substrate 21; and the fins 22 dissipate the heat through gas flowing in the air duct 25, thereby reducing a temperature of the package structure 50.

To improve heat dissipation efficiency of the heat sink 20 and reduce debugging difficulty of the captive elastic assembly 10, in some embodiments of this application, the first substrate surface 21a and the second substrate surface 21b that are of the substrate 21 are parallel to each other, to implement heat-conducting consistency of the substrate 21. Therefore, the heat sink 20 evenly dissipates heat from all points on the heat-conducting surface of the package structure 50, and heat dissipation effect of the heat sink 20 is optimized.

In another alternative implementation, the heat sink 20 may alternatively be a liquid-cooled plate-type heat sink.

FIG. 5 is a cross-sectional view of the bracket 30 along a section A-A in FIG. 2 according to Embodiment 1 of this application. The following describes in detail the specific structure of the bracket 30 with reference to FIG. 5.

With reference to FIG. 2, FIG. 4, and FIG. 5, in some embodiments of this application, it can be learned that the bracket 30 is a frame structure 31, a hollowed-out part 32 is formed in the frame structure 31, and the hollowed-out part 32 is configured to be penetrated through by the boss 23 in the heat sink 20. The frame structure 31 is formed with a first bracket surface 31a and a second bracket surface 31b that are opposite to each other and face away from each other. The frame structure 31 is further provided with a second through hole 33, and the second through hole 33 connects the first bracket surface 31a and the second bracket surface 31b. For ease of subsequent description, an aperture of the second through hole 33 is denoted as d2 in this application. With reference to the foregoing description, it can be learned that the captive elastic assembly 10 is mounted on the second through hole 33 of the bracket 30.

Specifically, with reference to FIG. 2, FIG. 4, and FIG. 5, it can be learned that when the heat sink 20 is mounted on the bracket 30, or the heat sink 20 is mounted on the bracket 30 and the circuit board 40, the first bracket surface 31a in the bracket 30 is configured to abut on the second substrate surface 21b in the heat sink 20, so that the bracket 30 is attached to the heat sink 20, and the boss 23 in the heat sink 20 penetrates through the hollowed-out part 32 in the bracket 30.

It may be understood that the foregoing heat sink 20 and the bracket 30 are used as an example for description in this embodiment of this application, and it is not that the captive elastic assembly 10 in this application is applicable only to the foregoing heat sink 20 and the bracket 30. The specific structures of the heat sink 20 and the bracket 30 are not limited in this application.

FIG. 6 is a cross-sectional view of the circuit board 40 and the package structure 50 along a section A-A in FIG. 2 according to Embodiment 1 of this application. The following describes in detail the specific structure of the circuit board 40 (including the package structure 50 mounted on the circuit board 40) with reference to FIG. 6.

As shown in FIG. 6, the circuit board 40 is formed with a first circuit board surface 40a and a second circuit board surface 40b that are opposite to each other and face away from each other. The circuit board 40 is further provided with a third through hole 41, the third through hole 41 connects the first circuit board surface 40a and the second circuit board surface 40b, and the third through hole 41 is opposite to the first through hole 24 and the second through hole 33. For ease of subsequent description, an aperture of the third through hole 41 is denoted as d3 in this application. With reference to the foregoing description, it can be learned that the captive elastic assembly 10 is mounted on the third through hole 41 of the circuit board 40. In addition, the circuit board 40 is further provided with the package structure 50, and a side surface that is of the package structure 50 and that faces away from the circuit board 40 is a heat-conducting surface 50a. To implement stable attachment between the heat sink 20 and the package structure 50, third through holes 41 are evenly distributed around the package structure 50.

Specifically, with reference to FIG. 2, FIG. 4, FIG. 5, and FIG. 6, it can be learned that when the heat sink 20 is mounted on the bracket 30 and the circuit board 40, the boss 23 in the heat sink 20 penetrates through the hollowed-out part 32 in the bracket 30, and the heat-absorbing surface 20a on the boss 23 is attached to the heat-conducting surface 50a of the package structure 50.

The circuit module 2 controls a relative position between the first through hole 24 and the heat-absorbing surface 20a, and controls a relative position between the third through hole 41 and the heat-conducting surface 50a, so that when the heat sink 20 and the bracket 30 are mounted on the circuit board 40 by using the captive elastic assembly 10 (that is, when axes of the first through hole 24, the second through hole 33, and the third through hole 41 coincide), it is ensured that the heat-absorbing surface 20a of the boss 23 in the heat sink 20 is aligned with the heat-conducting surface 50a of the package structure 50. Therefore, when heat dissipation effect is ensured, an area of the heat-absorbing surface 20a of the heat sink 20 can be reduced as much as possible, and manufacturing costs of the heat sink 20 are reduced.

After the descriptions of the heat sink 20, the bracket 30, and the circuit board 40 (including the package structure 50 mounted on the circuit board 40), this application continues to describe a specific structure and a working principle of the captive elastic assembly 10 configured to connect the heat sink 20, the bracket 30, and the circuit board 40 with reference to the specific structures of the heat sink 20, the bracket 30, and the circuit board 40 (including the package structure 50 mounted on the circuit board 40).

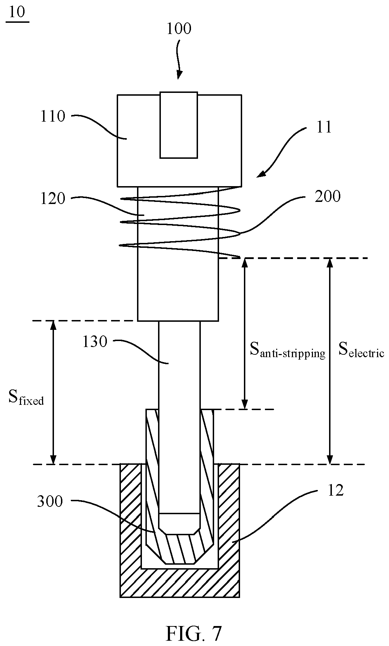

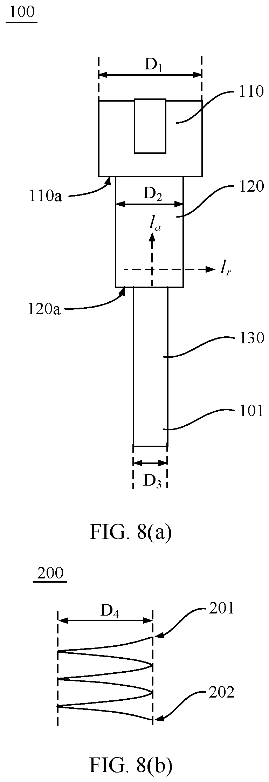

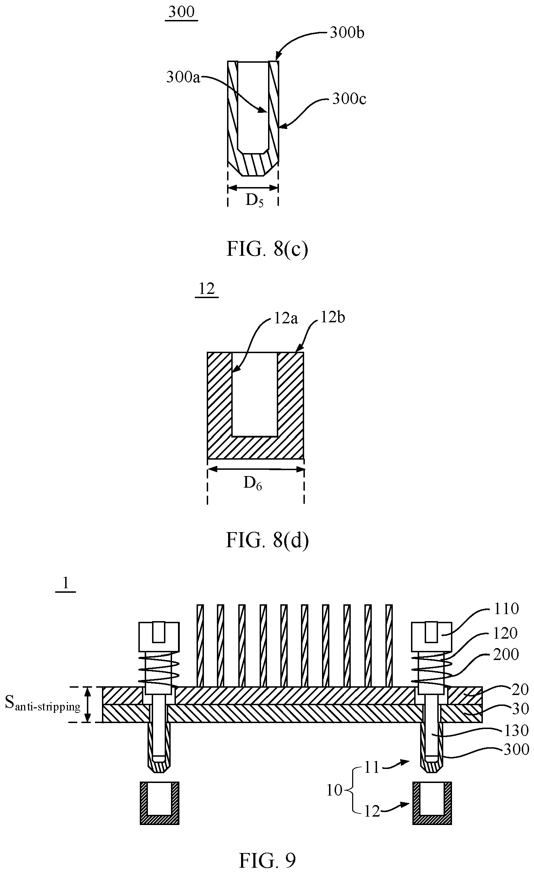

FIG. 7 is a cross-sectional view of the captive elastic assembly 10 along a section A-A in FIG. 2 according to Embodiment 1 of this application. FIG. 8(a) is a side view of a nail body 100 in a connecting component 11 according to Embodiment 1 of this application. FIG. 8(b) is a side view of an elastic element 200 in a connecting component 11 according to Embodiment 1 of this application. FIG. 8(c) is a cross-sectional view of an anti-stripping member 300 in a connecting component 11 along a section A-A in FIG. 2 according to Embodiment 1 of this application. FIG. 8(d) is a cross-sectional view of a fastening component 12 along a section A-A in FIG. 2 according to Embodiment 1 of this application. The following describes in detail the specific structure and the working principle of the captive elastic assembly 10 with reference to FIG. 2 to FIG. 8(d).

As shown in FIG. 7, Embodiment 1 of this application provides a captive elastic assembly 10. The captive elastic assembly 10 includes a connecting component 11 and a fastening component 12. The connecting component 11 includes a nail body 100, an elastic element 200, and an anti-stripping member 300.

Specifically, as shown in FIG. 8(a), the nail body 100 includes a connector 110, a large-diameter connecting rod 120, and a small-diameter connecting rod 130. For ease of subsequent description, in this application, an outer diameter of the connector 110 is denoted as a connector diameter D1, an outer diameter of the large-diameter connecting rod 120 is denoted as a large-diameter D2, and an outer diameter of the small-diameter connecting rod 130 is denoted as a small diameter D3. In addition, an axial direction of the large-diameter connecting rod 120 (or the small-diameter connecting rod 130) is defined as an axial direction la of the nail body (la in FIG. 8(a)), and a direction perpendicular to the axial direction of the nail body is defined as a radial direction lr of the nail body (lr in FIG. 8(a)).

It can be learned from FIG. 8(a) that the connector 110, the large-diameter connecting rod 120, and the small-diameter connecting rod 130 all extend along the axial direction la of the nail body (that is, rotation axes of the connector 110, the large-diameter connecting rod 120, and the small-diameter connecting rod 130 coincide), and the connector 110, the large-diameter connecting rod 120, and the small-diameter connecting rod 130 are sequentially connected. In addition, the connector diameter D1 of the connector 110 is greater than the large-diameter D2 of the large-diameter connecting rod 120, and the large-diameter D2 of the large-diameter connecting rod 120 is greater than the small diameter D3 of the small-diameter connecting rod 130.

Further, as shown in FIG. 8(a), an annular connector end face 110a is formed at an end that is of the connector 110 and that is connected to the large-diameter connecting rod 120. An annular large-diameter end face 120a is formed at an end that is of the large-diameter connecting rod 120 and that is connected to the small-diameter connecting rod 130. An end that is of the small-diameter connecting rod 130 and that is opposite to the connector 110 (that is, an end that is of the small-diameter connecting rod 130 and that faces away from the large-diameter connecting rod 120) is a mounting end 101 used to mount the anti-stripping member 300.

As shown in FIG. 8(b), the elastic element 200 is in a spiral rotary structure, and the elastic element 200 includes a first elastic end 201 and a second elastic end 202. In addition, an outer size of the elastic element 200 (an outer diameter of the elastic element 200 after screwing) is denoted as a spiral outer diameter D4 of the elastic element 200. In the captive elastic assembly 10, the elastic element 200 is sleeved on the large-diameter connecting rod 120 in the nail body 100, and the first elastic end 201 of the elastic element 200 can abut on the connector end face 110a of the connector 110. The second elastic end 202 of the elastic element 200 can be used to abut on the first substrate surface 21a of the heat sink 20.

As shown in FIG. 8(c), the anti-stripping member 300 is a screw cap, and the anti-stripping member 300 is formed with a mounting internal thread 300a that adapts to a mounting end of the nail body 100 and an anti-stripping end face 300b used to restrict the bracket 30 from being stripped from the heat sink 20. For ease of subsequent description, in this application, an outer diameter of the anti-stripping member 300 is denoted as an anti-stripping outer diameter D5. An end that is of the anti-stripping member 300 and that is opposite to the connector 110 (that is, one end that is of the anti-stripping member 300 and that faces away from the large-diameter connecting rod 120) and an end that is of the small-diameter connecting rod 130 and that is opposite to the connector 110 (that is, an end that is of the small-diameter connecting rod 130 and that faces away from the large-diameter connecting rod 120) are fastening ends (not shown) used to mount to the fastening component 12.

Specifically, when the anti-stripping member 300 is mounted on the nail body 100 through the mounting internal thread 300a, the anti-stripping end face 300b faces the large-diameter end face 120a of the large-diameter connecting rod 120 in the nail body 100. An anti-stripping spacing S_{anti-stripping} capable of restricting the bracket 30 from being stripped from the heat sink 20 can be formed between the elastic element 200 and the anti-stripping member 300. It may be understood that the anti-stripping spacing S_{anti-stripping} is a spacing between the anti-stripping end face 300b and the second elastic end 202 of the elastic element 200 after the captive elastic assembly 10 is mounted on the heat sink 20 and the bracket 30.

In some embodiments of this application, as shown in FIG. 8(c), the anti-stripping member 300 is further formed with a fastening external thread 300c that adapts to the fastening component 12. The anti-stripping member 300 is threadedly connected to the fastening component 12 through the fastening external thread 300c. To ensure connection strength between the nail body 100 and the anti-stripping member 300 and implementation of various functions in the circuit module 2, an outer peripheral surface of the fastening component 12 is completely provided with the fastening external thread 300c.

In another alternative embodiment, to reduce mounting difficulty of the anti-stripping member 300 and the nail body 100, an area that is of the outer peripheral surface of the fastening component 12 and that is closer to the anti-stripping end face 300b is provided with a mounting part, and an area that is of the outer peripheral surface of the fastening component 12 and that is further away from the anti-stripping end face 300b is provided with the fastening external thread 300c.

As shown in FIG. 8(d), the fastening component 12 is formed with a fastening internal thread 12a that adapts to the fastening external thread 300c of the anti-stripping member 300, and the connecting component 11 and the fastening component 12 are threadedly connected through the fastening external thread 300c and the fastening internal thread 12a. The captive elastic assembly 10 implements the fixed connection between the bracket 30 and the circuit board 40 by adjusting a length of the threaded connection between the connecting component 11 and the fastening component 12. For ease of subsequent description, in this application, an outer diameter of the fastening component 12 is denoted as a fastening outer diameter D6. The fastening component 12 is further formed with a fastening end face 12b.

Specifically, when the connecting component 11 is mounted on the fastening component 12, the fastening end face 12b faces the large-diameter end face 120a. A fixed spacing S_{fixed} capable of fastening the bracket 30 and the circuit board 40 is formed between the fastening component 12 and the large-diameter connecting rod 120. It may be understood that the fixed spacing S_{fixed} is a spacing between the fastening end face 12b of the fastening component 12 and the large-diameter end face 120a of the large-diameter connecting rod 120 after the heat sink 20 and the bracket 30 are mounted on the circuit board 40 by using the captive elastic assembly 10. An elastic spacing S_{elastic} capable of elastically combining the heat sink 20 to the bracket 30 is formed between the fastening component 12 and the elastic element 200. It may be understood that the elastic spacing S_{elastic} is a spacing between the fastening end face 12b of the fastening component 12 and the second elastic end 202 of the elastic element 200 after the heat sink 20 and the bracket 30 are mounted on the circuit board 40 by using the captive elastic assembly 10.

In another alternative implementation, a connection manner between the connecting component 11 and the fastening component 12 is self-clinching or anchor riveting. The anti-stripping spacing S_{anti-stripping}, the fixed spacing S_{fixed}, and the elastic spacing S_{elastic} are the same as those in the foregoing implementation. Details are not described again in this application.

The foregoing describes in detail the structure features of the components in the captive elastic assembly 10. The following describes assembly manners of the captive elastic assembly 10 on the heat sink 20, the bracket 30, and the circuit board 40 by using the heat dissipation apparatus 1 and the circuit module 2 with reference to the structure feature described above and working principles in which the captive elastic assembly 10 cooperates with the components to achieve the functions of anti-stripping, fixing, and elasticity.

First, according to the structure features of the captive elastic assembly 10, the heat sink 20, and the bracket 30, how the captive elastic assembly 10 in the heat dissipation apparatus 1 cooperates with the heat sink 20 and the bracket 30 to restrict the bracket 30 from being stripped from the heat sink 20 is described. FIG. 9 is a cross-sectional view of the heat dissipation apparatus 1 along a section A-A in FIG. 2 according to Embodiment 1 of this application.

As shown in FIG. 9, the heat dissipation apparatus 1 includes any one of the captive elastic assembly 10, the heat sink 20, and the bracket 30. With reference to FIG. 2 and FIG. 4 to FIG. 9, it can be learned that the connector diameter D1 of the connector 110 is greater than the spiral outer diameter D4 of the elastic element 200. The aperture d1 of the first through hole 24 in the heat sink 20 is less than the spiral outer diameter D4 of the elastic element 200, and the aperture d1 of the first through hole 24 is greater than the large-diameter D2 of the large-diameter connecting rod 120. The aperture d2 of the second through hole 33 in the bracket 30 is smaller than the large-diameter D2 of the large-diameter connecting rod 120 and the anti-stripping outer diameter D5 of the anti-stripping member 300, and the aperture d2 of the second through hole 33 is greater than the small diameter D3 of the small-diameter connecting rod 130. For example, the small-diameter connecting rod 130 is threadedly connected to the bracket 30.

The connector 110 is located on a side that is of the heat sink 20 and on which the first substrate surface 21a is formed, the large-diameter connecting rod 120 penetrates the first through hole 24 of the heat sink 20, the elastic element 200 is sleeved on the large-diameter connecting rod 120 between the connector 110 and the heat sink 20, the small-diameter connecting rod 130 penetrates through the second through hole 33 of the bracket 30, and the anti-stripping member 300 is mounted at an end (that is, the mounting end 101 of the nail body 100 shown in FIG. 8(a)) that is of the small-diameter connecting rod 130 and that penetrates out the second through hole 33. The nail body 100 and the elastic element 200 cooperate with the anti-stripping member 300 to restrict the bracket 30 from being stripped from the heat sink 20.

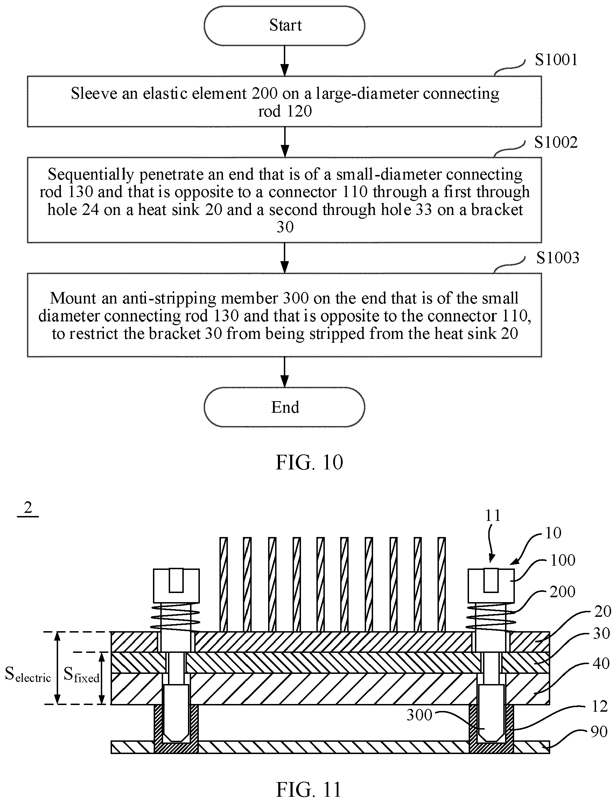

After the specific structure of the heat dissipation apparatus 1 is described, the following describes in detail an assembly method of the components in the heat dissipation apparatus 1 by using the foregoing heat dissipation apparatus 1 as an example. FIG. 10 shows a flowchart of an assembly method of the heat dissipation apparatus 1.

This application further provides an assembly method of the heat dissipation apparatus 1. As shown in FIG. 10, the assembly method of the heat dissipation apparatus 1 includes the following steps.

S1001: Sleeve the elastic element 200 on the large-diameter connecting rod 120. Specifically, the elastic element 200 is sleeved on the nail body 100 from the mounting end 101 of the small-diameter connecting rod 130, and the first elastic end 201 of the elastic element 200 can abut on the connector end face 110a of the connector 110.

S 1002: Sequentially penetrate the end (the mounting end 101 of the nail body 100) that is of the small-diameter connecting rod 130 and that is opposite to the connector 110 through the first through hole 24 on the heat sink 20 and the second through hole 33 on the bracket 30.

S1003: Mount the anti-stripping member 300 on the mounting end 101 that is of the nail body 100 and that penetrates out the second through hole 33, that is, mount the anti-stripping member 300 on the end that is of the small-diameter connecting rod 130 and that is opposite to the connector 110, to restrict the bracket 30 from being stripped from the heat sink 20.

In some embodiments of this application, the anti-stripping member 300 is threadedly connected to the mounting end 101 of the nail body 100. In another alternative implementation, the anti-stripping member 300 may also be connected to the mounting end 101 of the nail body 100 in another manner such as self-clinching or anchor riveting. This is not limited in this embodiment of this application.

Next, according to the structure features of the captive elastic assembly 10, the heat sink 20, the bracket 30, and the circuit board 40 (including the package structure 50 mounted on the circuit board 40), how the captive elastic assembly 10 in the circuit module 2 cooperates with the heat sink 20, the bracket 30, and the circuit board 40 (including the package structure 50 mounted on the circuit board 40) is described to fasten the bracket 30 to the circuit board 40 and to elastically combine the heat sink 20 to the bracket 30. FIG. 11 is a cross-sectional view of the circuit module 2 along a section A-A in FIG. 2 according to Embodiment 1 of this application;

As shown in FIG. 11, this application further provides a circuit module 2. The circuit module 2 includes any one of the heat dissipation apparatus 1, the circuit board 40, and the package structure 50 mounted on the circuit board 40. The heat dissipation apparatus 1 includes a captive elastic assembly 10, a heat sink 20, and a bracket 30.

With reference to FIG. 4 to FIG. 11, it can be learned that, the aperture d3 of the third through hole 41 on the circuit board 40 is greater than the anti-stripping outer diameter D5 of the anti-stripping member 300, and the aperture d3 of the third through hole 41 is less than the fastening outer diameter D6 of the fastening component 12.

Specifically, the heat sink 20 is configured to dissipate heat for the package structure 50 on the circuit board 40, the package structure 50 is provided with the heat-conducting surface 50a, and the heat sink 20 is provided with the heat-absorbing surface 20a that adapts to the heat-conducting surface 50a. The circuit board 40 is located on a side that is of the bracket 30 and that faces away from the heat sink 20, the package structure 50 mounted on the circuit board 40 faces the heat sink 20, and the heat-conducting surface 50a of the package structure 50 penetrates through a hollowed-out part 32 (as shown in FIG. 2) of the bracket 30 and abuts on the heat-absorbing surface 20a of a boss 23 of the heat sink 20.

In another alternative implementation, the side that is of the bracket 30 and that faces away from the heat sink 20 is provided with a countersink hole. The countersink hole is coaxially disposed with the second through hole 33 on the bracket 30, and an aperture of the countersink hole is greater than the anti-stripping outer diameter D5 of the anti-stripping member 300. In this implementation, a size relationship between the aperture d3 of the third through hole 41 in the circuit board 40 and the anti-stripping outer diameter D5 of the anti-stripping member 300 is not specifically limited.

When a fastening end of the connecting component 11 is mounted on the fastening component 12 through the third through hole 41 on the circuit board 40, to mount the heat sink 20 and the bracket 30 on the circuit board 40, the third through hole 41 on the circuit board 40 is opposite to the first through hole 24 and the second through hole 33. The fastening end includes the end that is of a small-diameter connecting rod 130 and that is opposite to a connector 110 and the anti-stripping member 300, and the fastening external thread 300c is arranged on the outer periphery of the anti-stripping member 300. The fastening component 12 is screwed to the fastening external thread 300c through the fastening internal thread 12a to be threadedly mounted with the fastening end. The first elastic end 201 of the elastic element 200 abuts on the connector end face 110a of the connector 110, and the second elastic end 202 of the elastic element 200 abuts on the first substrate surface 21a of the heat sink 20. The heat-absorbing surface 20a of the heat sink 20 elastically abuts on the heat-conducting surface 50a of the package structure 50 on the circuit board 40 (that is, the second substrate surface 21b of the heat sink 20 abuts on the first bracket surface 31a of the bracket 30). The second bracket surface 31b of the bracket 30 abuts on the first circuit board surface 40a of the circuit board 40. The second circuit board surface 40b of the circuit board 40 abuts on the fastening end face 12b of the fastening component 12.

The large-diameter connecting rod 120 and the fastening component 12 tightly press the bracket 30 and the circuit board 40 by using the large-diameter end face 120a and the fastening end face 12b, to fasten the bracket 30 and the circuit board 40. The heat sink 20 is elastically combined to the bracket 30 through elastic deformation of the elastic element 200, so that the heat-absorbing surface 20a of the heat sink 20 elastically abuts on the heat-conducting surface 50a of the package structure 50.

In some embodiments of this application, there are four captive elastic assemblies 10, and the four captive elastic assemblies 10 are arrayed at four top corners of the bracket 30.

It may be understood that a quantity of the captive elastic assemblies 10 is not specifically limited in this application. To improve structural stability of the heat dissipation apparatus 1, in some embodiments of this application, the quantity of the captive elastic assemblies 10 may be an even number, and the captive elastic assemblies 10 are symmetrically distributed on two sides of a center line of the package structure 50. In alternative other embodiments, the quantity of the captive elastic assemblies 10 may be an odd number. It may be understood that the quantity of the captive elastic assemblies 10 is sufficient to stably connect the heat sink 20, the bracket 30, and the circuit board 40. This is not specifically limited in this application.

In some embodiments of this application, as shown in FIG. 11, the circuit module 2 further includes a fireproof panel 90. The fireproof panel 90 is disposed on a side that is of the circuit board 40 and that faces away from the package structure 50, and the fastening component 12 is disposed on the fireproof panel 90. For example, the fastening component 12 is embedded into the fireproof panel 90. The fireproof panel 90 is configured to prevent a fire caused by an excessively high temperature of the package structure 50 on the circuit board 40.

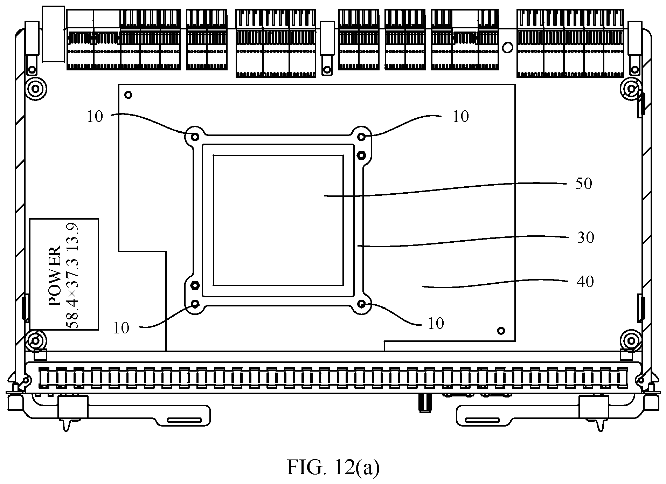

According to the technical solution in this application, FIG. 12(a) is a schematic top view of the circuit module 2 (the heat sink is not shown). The circuit module 2 in the technical solution of this application includes four captive elastic assemblies 10. A fixed connection between the bracket 30 and the circuit board 40 and an elastic combination between the heat sink and the bracket 30 can be implemented by using the four elastic assemblies 10. In the foregoing circuit module 2, each of the heat sink, the bracket 30, and the circuit board 40 only needs to be provided with four mounting holes. Therefore, occupation of mounting space on a board surface of the circuit board 40 can be reduced, thereby improving utilization of the board surface of the circuit board 40 and improving mounting efficiency of the circuit module.

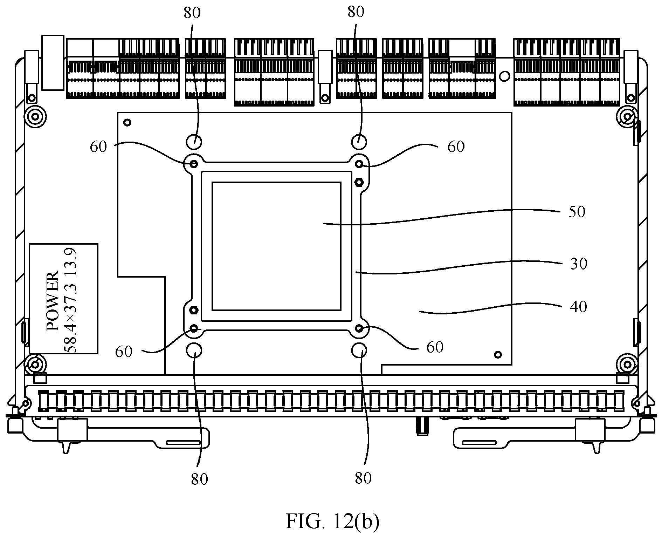

FIG. 12(b) is a schematic top view of the circuit module 2 in another technical solution (the heat sink is not shown). As shown in FIG. 12(b), in addition to the heat sink, the bracket 30, the circuit board 40, and the package structure 50 mounted on the circuit board 40, the circuit module 2 further includes a bracket screw 60 configured to mount the bracket 30 on the circuit board 40, a positioning pin 70 configured to determine a relative position between the bracket 30 and the circuit board 40 and a relative position between the heat sink and the bracket 30, and a heat sink screw 80 configured to mount the heat sink on the circuit board 40 or mount the heat sink on the bracket 30. It can be learned from FIG. 3(a) and FIG. 3(b) that, to implement stable connection of the heat sink, the bracket 30, and the circuit board 40, the circuit module 2 includes four bracket screws 60, two positioning pins 70, and four heat sink screws 80. In other words, a total of 10 connecting pieces are required to complete mounting of the heat sink, the bracket 30, and the circuit board 40 that are in the circuit module 2.

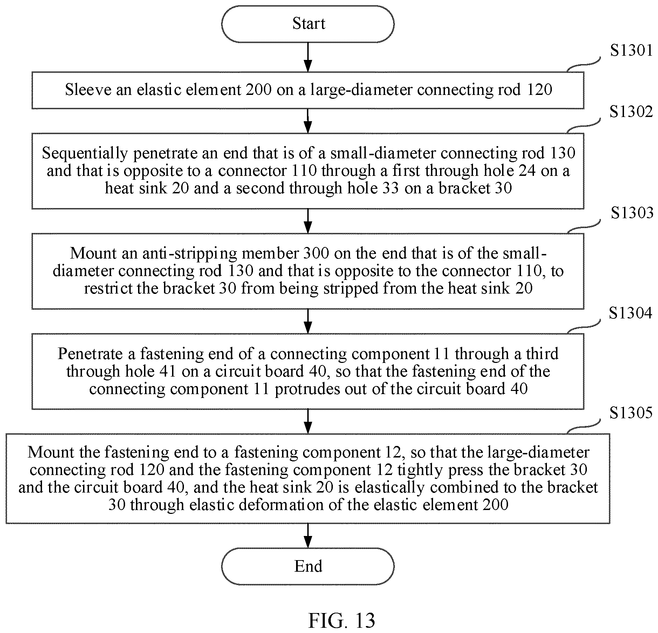

After the specific structure of the circuit module 2 is described, the following describes in detail an assembly method of the captive elastic assembly 10, the heat sink 20, the bracket 30, and the circuit board 40 (including the package structure 50 mounted on the circuit board 40) that are in the circuit module 2 by using the foregoing circuit module 2 as an example. FIG. 13 shows a flowchart of an assembly method of the circuit module 2.

This application further provides the assembly method of the circuit module 2. As shown in FIG. 13, the assembly method of the circuit module 2 includes the following steps.

S1301: Step S1301 is the same as step S1001, and details are not described herein again.

S1302: Step S1302 is the same as step S1002, and details are not described herein again.

S1303: Step S1303 is the same as step S1003, and details are not described herein again.

S1304: The connecting component 11 penetrates through the third through hole 41 on the circuit board 40, so that the fastening end of the connecting component 11 protrudes out of the circuit board 40.

S1305: Mount the fastening end to the fastening component 12, so that the large-diameter connecting rod 120 and the fastening component 12 tightly press the bracket 30 and the circuit board 40, and the heat sink 20 is elastically combined to the bracket 30 through elastic deformation of the elastic element 200.

Specifically, the fastening end of the connecting component 11 is mounted on the fastening component 12, so that the large-diameter connecting rod 120 and the fastening component 12 tightly press the bracket 30 and the circuit board 40 to fasten the bracket 30 to the circuit board 40 by adjusting a length of the threaded connection between the fastening component 12 and the anti-stripping member 300 and a length of the threaded connection between the small-diameter connecting rod 130 and the anti-stripping member 300. At the same time, elastic deformation of the elastic element 200 can be adjusted to elastically combine the heat sink 20 to the bracket 30 by adjusting the length of the threaded connection between the small-diameter connecting rod 130 and the anti-stripping member 300 and the length of the threaded connection between the small-diameter connecting rod 130 and the anti-stripping member 300.

In another alternative implementation, when a connection manner between the connecting component 11 and the fastening component 12 is riveting, step S1304 and step S1305 in the foregoing assembly method of the circuit module 2 include: penetrating the connecting component 11 through the third through hole 41 on the circuit board 40, so that the fastening end of the connecting component 11 protrudes out of the circuit board 40. The fastening end of the connecting component 11 is mounted on the fastening component 12, so that the bracket 30 is fastened to the circuit board 40 by adjusting the length of the threaded connection between the fastening component 12 and the anti-stripping member 300, and the heat sink 20 is elastically combined to the bracket 30 under an action of elastic deformation.

Further, this application further provides an electronic device, including at least one of the foregoing circuit modules 2.

### Embodiment 2

In Embodiment 2 of this application, a captive elastic assembly 10 includes a connecting component 11 and a fastening component 12. The connecting component 11 includes a nail body 100, an elastic element 200, and an anti-stripping member 300. The anti-stripping member 300 is a screw cap, and the anti-stripping member 300 is formed with a mounting internal thread 300a that adapts to a mounting end 101 of the nail body 100 and an anti-stripping end face 300b used to restrict a bracket 30 from being stripped from a heat sink 20. The anti-stripping member 300 is further formed with a fastening external thread 300c that adapts to the fastening component 12. The anti-stripping member 300 is threadedly connected to the fastening component 12 through the fastening external thread 300c.

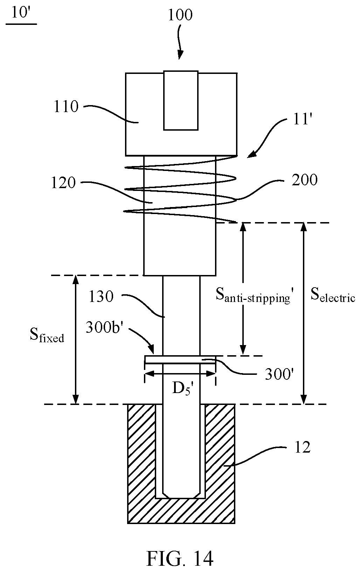

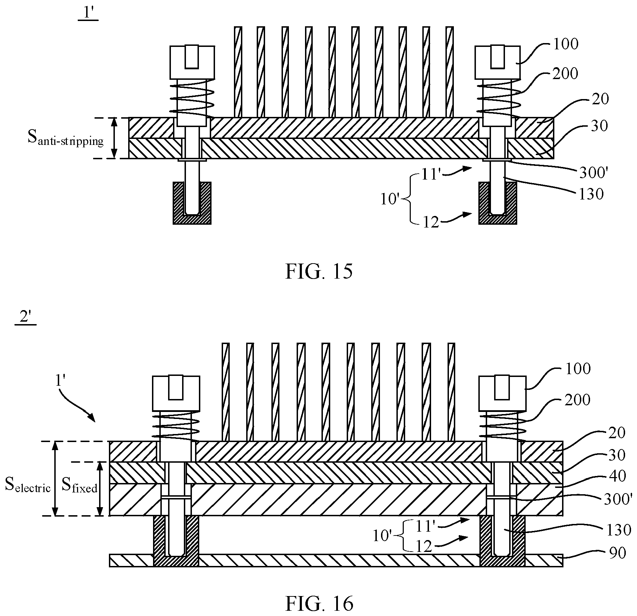

FIG. 14 is a cross-sectional view of a captive elastic assembly 10' along a section A-A in FIG. 2 according to Embodiment 2 of this application. FIG. 15 is a sectional view of a heat dissipation apparatus 1' along a section A-A in FIG. 2 according to Embodiment 2 of this application. FIG. 16 is a cross-sectional view of a circuit module 2' along a section A-A in FIG. 2 according to Embodiment 2 of this application.

A working principle of Embodiment 2 of this application is the same as that of Embodiment 1 of this application. A difference lies in that, as shown in FIG. 14, an anti-stripping member 300' in the captive elastic assembly 10' is a stopper. The stopper is clamped to a small-diameter connecting rod 130, and an anti-stripping spacing S_{anti-stripping}' is a spacing between an anti-stripping end face 300b' and a second elastic end 202 of the elastic element 200 after the captive elastic assembly 10' is mounted on the heat sink 20 and bracket 30. The stopper is configured to adjust the anti-stripping spacing S_{anti-stripping}' by adjusting a clamping position between the stopper and the small-diameter connecting rod 130.

In addition, in Embodiment 2 of this application, a fastening end that is of a connecting component 11' and that is mounted on the fastening component 12 is also changed compared with the fastening end in Embodiment 1 of this application. Specifically, in Embodiment 2 of this application, the fastening end includes an end that is of the small-diameter connecting rod 130 and that is opposite to a connector 110, and a fastening external thread (not shown) is arranged on the end of the small-diameter connecting rod 130. The fastening component 12 is provided with a fastening internal thread. The fastening internal thread of the fastening component 12 is screwed to the fastening external thread of the small-diameter connecting rod 130, so that a fastening end of the connecting component 11' is threadedly mounted with the fastening component 12.

Embodiment 2 of this application further provides a heat dissipation apparatus 1'. As shown in FIG. 15, a structure of the heat dissipation apparatus 1' is basically the same as the structure of the heat dissipation apparatus 1 in Embodiment 1 of this application. A difference lies in that the captive elastic assembly 10' used by the heat dissipation apparatus 1' in Embodiment 2 is the captive elastic assembly 10' provided in any implementation of Embodiment 2 of this application. A specific structure of the heat dissipation apparatus 1' in Embodiment 2 of this application is not described again.

Embodiment 2 of this application further provides a circuit module 2'. As shown in FIG. 16, a structure of the circuit module 2' is basically the same as the structure of the circuit module 2 in Embodiment 1 of this application. A difference lies in that the heat dissipation apparatus 1' used by the circuit module 2' in Embodiment 2 is the heat dissipation apparatus 1' provided in any implementation of Embodiment 2 of this application. A specific structure of the circuit module 2' in Embodiment 2 of this application is not described again.

Embodiment 2 of this application further provides an assembly method of the circuit module 2'. The assembly method of the circuit module 2' is basically the same as the assembly method of the circuit module 2 in Embodiment 1 of this application. A difference lies in that the assembled circuit module 2' in the assembly method of the circuit module 2' in Embodiment 2 is the circuit module 2' provided in any implementation of Embodiment 2 of this application, so that the method for mounting the stopper on the small-diameter connecting rod 130 and the method for mounting the connecting component 11' on the fastening component 12 are changed.

Specifically, the mounting method of the anti-stripping member 300' in the circuit module 2' is as follows: when the end that is of the small-diameter connecting rod 130 of the nail body 100 and that is opposite to the connector 110 penetrates through a first through hole 24 on the heat sink 20 and a second through hole 33 on the bracket 30, clamping the limit plate to the small-diameter connecting rod 130. The method for mounting the fastening end of the connecting component 11' to the fastening component 12 is that the end that is of the small-diameter connecting rod 130 of the nail body 100 and that is opposite to the connector 110 is mounted on the fastening component 12 as the fastening end. In addition, other steps of the assembly method of the circuit module 2' in Embodiment 2 of this application are the same as those of the assembly method of the circuit module 2 in Embodiment 1 of this application. Details are not described herein again.

Embodiment 2 of this application further provides an electronic device. A structure of the electronic device is basically the same as the structure of the electronic device in Embodiment 1 of this application. A difference lies in that the circuit module 2' used by the electronic device in Embodiment 2 is the circuit module 2' provided in any implementation of Embodiment 2 of this application. A specific structure of the electronic device in Embodiment 2 of this application is not described again.

It should be noted that, in this specification, reference numerals and letters in the following accompanying drawings represent similar items. Therefore, once an item is defined in an accompanying drawing, the item does not need to be further defined or interpreted in the following accompanying drawings. In the descriptions of this application, it should be noted that orientation or location relationships indicated by terms "center", "above", "below", "left", "right", "vertical", "horizontal", "inner", "outer" and the like are orientation or location relationships based on the accompanying drawings, and are merely intended for conveniently describing this application and simplifying descriptions, rather than indicating or implying that an indicated apparatus or element needs to have a specific orientation or needs to be constructed and operated in a specific orientation, and therefore cannot be constructed as a limitation on this application. In addition, the terms "first" and "second" are merely used for a purpose of description, and shall not be understood as an indication or implication of relative importance. In the descriptions of this application, it should be noted that: unless otherwise explicitly specified and limited, the terms "mounting", "connecting", and "connection" should be understood in a broad sense. For example, there may be a fixed connection, a detachable connection, or an integral connection; may be a mechanical connection or an electrical connection; or may be a direct connection or an indirect connection through an intermediate medium, or may be an internal connection between two elements. For a person of ordinary skill in the art, a specific meaning of the foregoing terms in this application may be understood according to a specific situation. To make the objectives, technical solutions, and advantages of this application clearer, the foregoing further describes implementations of this application in detail with reference to the accompanying drawings.

References to "some embodiments" or "embodiments" in this specification mean that the specific features, structures, or characteristics described with reference to embodiments are included in at least one example implementation or technology according to the present disclosure. In this specification, the phrases "in an embodiment" do not necessarily all represent a same embodiment. Although this application is described with reference to some embodiments, it does not mean that a characteristic of this application is limited only to this implementation. On the contrary, a purpose of describing this application with reference to an implementation is to cover another option or modification that may be derived based on claims of this application. To provide an in-depth understanding of this application, the foregoing descriptions include a plurality of specific details. This application may be alternatively implemented without using these details.

In addition, the language used in this specification has been primarily chosen for readability and instructional purposes and may not be chosen to depict or limit the disclosed subject matter. Therefore, this disclosure is intended to illustrate, rather than limit, the scope of the concepts discussed herein.

## Claims

1. A captive elastic assembly, comprising: a connecting component and a fastening component, wherein
the connecting component comprises a nail body, an elastic element, and an anti-stripping member, and the nail body comprises a connector, a large-diameter connecting rod, and a small-diameter connecting rod that are sequentially connected; the elastic element is sleeved on the large-diameter connecting rod and abuts on the connector, the anti-stripping member is mounted on the small-diameter connecting rod, and the fastening component is mounted on a fastening end that is of the connecting component and that is opposite to the connector;
an anti-stripping spacing capable of restricting a second member from being stripped from a first member is formed between the elastic element and the anti-stripping member;
a fixed spacing capable of fastening the second member and a third member is formed between the fastening component and the large-diameter connecting rod; and
an elastic spacing capable of elastically combining the first member to the second member is formed between the fastening component and the elastic element.

2. The captive elastic assembly according to claim 1, wherein the anti-stripping member comprises a screw cap, the screw cap is threadedly connected to an end that is of the small-diameter connecting rod and that is opposite to the connector, and the screw cap is used to adjust the anti-stripping spacing by adjusting a length of the threaded connection between the screw cap and the small-diameter connecting rod.

3. The captive elastic assembly according to claim 2, wherein the fastening end comprises the screw cap and the end that is of the small-diameter connecting rod and that is opposite to the connector, and an external thread is arranged on an outer periphery of the screw cap, and the fastening component is screwed to the external thread through an internal thread of the fastening component to be threadedly mounted with the fastening end.

4. The captive elastic assembly according to claim 2, wherein the fastening end comprises the screw cap and the end that is of the small-diameter connecting rod and that is opposite to the connector, and the fastening component is mounted on the fastening end through self-clinching or anchor riveting.

5. The captive elastic assembly according to claim 1, wherein the anti-stripping member comprises a stopper, the stopper is clamped to the small-diameter connecting rod, and the stopper is configured to adjust the anti-stripping spacing by adjusting a clamping position between the stopper and the small-diameter connecting rod.

6. The captive elastic assembly according to claim 5, wherein the fastening end comprises the end that is of the small-diameter connecting rod and that is opposite to the connector, and an external thread is arranged on an outer periphery of the end, and the fastening component is screwed to the external thread through an internal thread of the fastening component to be threadedly mounted with the fastening end.

7. A heat dissipation apparatus, comprising: a heat sink, a bracket, and the captive elastic assembly according to any one of claims 1 to 6, wherein
the heat sink is used as the first member, the heat sink is provided with a first through hole, and an aperture of the first through hole is less than a spiral outer diameter of the elastic element;
the bracket is used as the second member, the bracket is provided with a second through hole, and an aperture of the second through hole is smaller than a diameter of the large-diameter connecting rod and an outer diameter of the anti-stripping member;
the connector is located on a side of the heat sink, the large-diameter connecting rod penetrates the first through hole, the elastic element is sleeved on the large-diameter connecting rod between the connector and the heat sink, the small-diameter connecting rod penetrates through the second through hole, and the anti-stripping member is mounted on an end that is of the small-diameter connecting rod and that penetrates out the second through hole; the elastic element and the anti-stripping member are capable of restricting the bracket from being stripped from the heat sink;
when the connecting component penetrates through the third member and is mounted on the fastening component, to mount the heat sink and the bracket on the third member, the large-diameter connecting rod and the fastening component tightly press the bracket and the third member; and the heat sink is elastically combined to the bracket through elastic deformation of the elastic element.

8. The heat dissipation apparatus according to claim 7, wherein a quantity of the captive elastic assemblies is 4, and the four captive elastic assemblies are distributed in an array in an area in which the bracket is located.

9. A circuit module, comprising the heat dissipation apparatus according to claim 7 or 8, a circuit board, and a package structure mounted on the circuit board, wherein
the circuit board is used as the third member, and the circuit board is provided with a third through hole corresponding to the first through hole and the second through hole; and
the connecting component is mounted on the fastening component through the third through hole, the large-diameter connecting rod and the fastening component tightly press the bracket and the circuit board, and the heat sink is elastically combined to the bracket through elastic deformation of the elastic element.

10. The circuit module according to claim 9, wherein the circuit module further comprises a fireproof panel, the fireproof panel is disposed on a side that is of the circuit board and that is away from the package structure, and the fastening component is disposed on the fireproof panel.

11. An electronic device, comprising the circuit module according to claim 9 or 10.

12. An assembly method of a circuit module, comprising: assembling the circuit module according to claim 9 or 10, wherein the assembling method comprises:
sleeving the elastic element on the large-diameter connecting rod;
sequentially penetrating the end that is of the small-diameter connecting rod and that is opposite to the connector through the first through hole on the heat sink and the second through hole on the bracket;
mounting the anti-stripping member on the end that is of the small-diameter connecting rod and that is opposite to the connector, to restrict the bracket from being stripped from the heat sink;
penetrating the fastening end of the connecting component through the third through hole on the circuit board; and
mounting the fastening end on the fastening component, so that the large-diameter connecting rod and the fastening component tightly press the bracket and the circuit board, and the heat sink is elastically combined to the bracket through elastic deformation of the elastic element.
